# EUROPEAN PATENT SPECIFICATION

(11) **EP 3 278 981 B1**
(45) Date of publication and mention of the grant of the patent: **14.08.2019**
(21) Application number: 16771793.3
(22) Date of filing: 30.03.2016
(51) Int. Cl.: B32B 27/00, B32B 27/18, B65D 65/40, G09F 9/00, H01L 31/048, H05B 33/04, C08J 7/04, C09D 143/02

(54) **ANTISTATIC SHEET, AND PACKAGING MATERIAL AND ELECTRONIC DEVICE THAT INCLUDE THE SAME**
ANTISTATISCHE FOLIE UND VERPACKUNGSMATERIAL UND ELEKTRONISCHE VORRICHTUNG DAMIT
FEUILLE ANTISTATIQUE ET MATÉRIAU D'EMBALLAGE ET DISPOSITIF ÉLECTRONIQUE LA COMPRENANT

(30) Priority: 31.03.2015 JP 2015072585
(43) Date of publication of application: 07.02.2018
(73) Proprietor: Kuraray Co., Ltd., Kurashiki-shi, Okayama 710-0801 (JP)
(72) Inventor: INUBUSHI, Yasutaka, Kurashiki-shi Okayama 713-8550 (JP); SASAKI, Ryoichi, Kurashiki-shi Okayama 713-8550 (JP)
(74) Representative: Müller-Boré & Partner Patentanwälte PartG mbB
(86) International application number: PCT/JP2016/001861
(87) International publication number: WO 2016/157907

(56) References cited:
- WO-A1-2014/122940
- WO-A1-2014/122942
- WO-A1-2016/024381
- WO-A1-2016/024382
- JP-A- 2013 208 794

## Description

### TECHNICAL FIELD

The present invention relates to an antistatic sheet and to a packaging material and an electronic device that include the antistatic sheet.

### BACKGROUND ART

Multilayer structures in which a gas barrier layer containing aluminum or aluminum oxide as a component is formed on a plastic film have been conventionally well-known. Such multilayer structures are used as packaging materials for protecting articles (such as foods) which are susceptible to quality change induced by oxygen. In many cases, such a gas barrier layer is formed on a plastic film by a dry process such as physical vapor deposition or chemical vapor deposition. Aluminum-deposited films have light shielding properties as well as gas barrier properties and are typically used as packaging materials for dry foods. Aluminum oxide-deposited films, which have transparency, are characterized by allowing visual recognition of contained substances and by enabling check for foreign matters with a metal detector and heating with a microwave oven. Such films are therefore used as packaging materials in a wide variety of applications such as retort food packaging.

For example, Patent Literature 1 discloses a gas barrier layer containing aluminum, the gas barrier layer being a transparent gas barrier layer composed of a reaction product of aluminum oxide particles and a phosphorus compound. Patent Literature 1 discloses a method for forming the gas barrier layer, in which a coating liquid containing aluminum oxide particles and a phosphorus compound is applied onto a plastic film, then dried and heat-treated.

Conventional gas barrier layers as mentioned above have good gas barrier properties, indeed. However, they have a high surface electrical resistivity and are unsatisfactory for use in applications that require antistatic performance as well as gas barrier properties.

As for means for imparting antistatic performance, Patent Literature 2 discloses a gas-barrier in-mold label having an antistatic layer. Patent Literature 2 states that the in-mold label has water vapor barrier properties. However, Patent Literature 2 makes no mention of whether the in-mold label has oxygen barrier properties. Additionally, the production of the in-mold label involves complicated steps, since many layers including the antistatic layer should be sequentially stacked in a predefined order. Patent Literature 3 discloses a multilayer structure comprising at least one base (X), at least one layer (Y), and at least one layer (Z), wherein the layer (Y) contains an aluminum atom; the layer (Z) contains a polymer (E) having a plurality of phosphorus atoms; the polymer (E) is a polymer of at least one monomer comprising a vinylphosphonic acid compound, and the multilayer structure comprises at least one pair of the layer (Y) and the layer (Z) that are contiguously stacked. The layer (Y) is a layer (YA) containing a reaction product (R) formed by reaction between a metal oxide (A) containing aluminum and a phosphorus compound (B). The base (X) comprises at least one layer selected from the group consisting of a thermoplastic resin film layer, a paper layer, and an inorganic deposited layer. The multilayer sheet can be used as a packaging material for electronic device. Patent Literature 3 does not relate to a multilayer structure that has antistatic performance.

### CITATION LIST

### Patent Literature

Patent Literature 1: WO 2011/122036 A1
Patent Literature 2: JP 2011-5836 A
Patent Literature 3: WO 2014/122942 A1

### SUMMARY OF INVENTION

### Technical Problem

An object of the present invention is to provide: a novel antistatic sheet having high gas barrier performance, high water vapor barrier performance, and antistatic performance; and a packaging material and an electronic device that include the antistatic sheet.

### Solution to Problem

Through a detailed study, the present inventors have found that the above object can be achieved by providing an antistatic sheet including a multilayer structure including particular layers and have made the present invention on the basis of the finding.

The present invention provides an antistatic sheet including a multilayer structure including a base (X) and a layer (Y) stacked on the base (X), wherein the layer (Y) contains an aluminum-containing compound (A) and a polymer (BO) having a phosphonic acid unit, and the layer (Y) has a surface electrical resistivity of 1.0 × 10⁶ Ω/sq or more and 4.0 × 10¹³ Ω/sq or less.

In the antistatic sheet of the present invention, the aluminum-containing compound (A) may be a compound (Ab) including a reaction product (D) of an aluminum-containing metal oxide (Aa) and an inorganic phosphorus compound (BI).

In the antistatic sheet of the present invention, a ratio W_{BO}/W_{BI} between a weight W_{BI} of the inorganic phosphorus compound (BI) and a weight W_{BO} of the polymer (BO) having the phosphonic acid unit in the layer (Y) is less than 0.32.

In the antistatic sheet of the present invention, the polymer (BO) having the phosphonic acid unit may be a homopolymer or a copolymer of an alkenylphosphonic acid represented by the following general formula [III]:

R⁵-P(=O)(OH)₂ [III],

wherein R⁵ is an optionally substituted alkenyl group having 2 to 30 carbon atoms.

In the antistatic sheet of the present invention, the polymer (BO) having the phosphonic acid unit may be poly(vinylphosphonic acid).

In the antistatic sheet of the present invention, the base (X) may include at least one layer selected from the group consisting of a thermoplastic resin film layer, a paper layer, and an inorganic deposited layer.

In the antistatic sheet of the present invention, a moisture permeability as measured at 40°C and 90% RH may be 2.0 g/(m²•day) or less.

The present invention also provides a packaging material including any of the antistatic sheets as defined above. The present invention further provides an electronic device including any of the antistatic sheets as defined above.

### Advantageous Effects of Invention

According to the present invention, it is possible to obtain an antistatic sheet having superior gas barrier performance and water vapor barrier performance and further having superior antistatic performance. The antistatic sheet of the present invention can be produced by a simple process and is therefore industrially advantageous. Due to having superior antistatic performance, the antistatic sheet of the present invention does not suffer from appearance defect caused by adhesion of fine powder to the surface of the sheet.

### BRIEF DESCRIPTION OF DRAWINGS

FIG. 1 is a schematic diagram of an example of a vertical form-fill-seal bag according to the present invention.
FIG. 2 is a schematic diagram of an example of a flat pouch according to the present invention.
FIG. 3 is a schematic diagram of an example of a vacuum insulator according to the present invention.
FIG. 4 is a cross-sectional view showing a part of an example of an electronic device according to the present invention.
FIG. 5 is a scanning electron microscope photograph of a cross-section of a multilayer structure obtained in Example 1.
FIG. 6 is a scanning electron microscope photograph of a cross-section of a multilayer structure obtained in Example 2.

### DESCRIPTION OF EMBODIMENTS

Hereinafter, the present invention will be described with reference to examples. The following description gives examples of materials, conditions, techniques, and value ranges; however, the present invention is not limited to those mentioned as examples. The materials given as examples may be used alone or may be used in combination with one another, unless otherwise specified.

Unless otherwise specified, the meaning of an expression like "a particular layer is stacked on a particular member (such as a base or layer)" as used herein encompasses not only the case where the particular layer is stacked in contact with the member but also the case where the particular layer is stacked above the member, with another layer interposed therebetween. The same applies to expressions like "a particular layer is formed on a particular member (such as a base or layer)" and "a particular layer is disposed on a particular member (such as a base or layer)". Unless otherwise specified, the meaning of an expression like "a liquid (such as a coating liquid) is applied onto a particular member (such as a base or layer)" encompasses not only the case where the liquid is applied directly to the member but also the case where the liquid is applied to another layer formed on the member.

Herein, a layer may be termed "layer (Y)" using a reference character "(Y)" to differentiate the layer from other layers. The reference character "(Y)" has no technical meaning, unless otherwise specified. The same applies to other reference characters used in the terms such as "base (X)" and "compound (A)". However, an exception is made for the terms such as "hydrogen atom (H)" in which the reference character obviously represents a specific element.

### [Antistatic sheet]

The antistatic sheet of the present invention may consist essentially of a multilayer structure. The antistatic sheet of the present invention has high gas barrier performance, high water vapor barrier performance, and antistatic performance as long as the multilayer structure includes a layer (Y), even if the layer (Y) is not the outermost layer of the multilayer structure. The multilayer structure is therefore not limited to that which includes a layer (Y) as the outermost layer.

### [Multilayer structure]

The multilayer structure of the present invention includes a base (X) and a layer (Y). The layer (Y) contains an aluminum-containing compound (A) (this compound may be simply referred to as "compound (A)" hereinafter) and a polymer (BO) having a phosphonic acid unit (this polymer may be simply referred to as "polymer (BO)" hereinafter). It is preferable for the layer (Y) to further contain an inorganic phosphorus compound (BI). The term "multilayer structure" as used in the following description refers to a multilayer structure that includes the base (X) and the layer (Y), unless otherwise specified.

In the layer (Y), at least a part of the compound (A) may react with at least a part of the inorganic phosphorus compound (BI) and/or at least a part of the polymer (BO). When the compound (A) has undergone a reaction in the layer (Y), a moiety derived from the compound (A) in the reaction product is regarded as the compound (A). In this case, the weight of the compound (A) used in the formation of the reaction product (the weight of the compound (A) that has yet to undergo the reaction) is included in the weight of the compound (A) in the layer (Y). When the inorganic phosphorus compound (BI) and/or polymer (BO) has undergone a reaction in the layer (Y), a moiety derived from the inorganic phosphorus compound (BI) and/or polymer (BO) in the reaction product is regarded as the inorganic phosphorus compound (BI) and/or polymer (BO). In this case, the weight of the inorganic phosphorus compound (BI) and/or polymer (BO) used in the formation of the reaction product (the weight of the inorganic phosphorus compound (BI) and/or polymer (BO) that has yet to undergo the reaction) is included in the weight of the inorganic phosphorus compound (BI) and/or polymer (BO) in the layer (Y).

### [Base (X)]

The material of the base (X) is not particularly limited, and a base made of any of various materials can be used. Examples of the material of the base (X) include: resins such as thermoplastic resins and thermosetting resins; fiber assemblies such as fabrics and paper; wood; glass; metals; and metal oxides. Among these, thermoplastic resins and fiber assemblies are preferred, and thermoplastic resins are more preferred. The form of the base (X) is not particularly limited. The base (X) may be a laminar base such as a film or sheet. The base (X) preferably includes at least one layer selected from the group consisting of a thermoplastic resin film layer, a paper layer, and an inorganic deposited layer. In this case, the base may be a single-layer or multilayer base. The base (X) more preferably includes a thermoplastic resin film layer and may include an inorganic deposited layer (X') in addition to the thermoplastic resin film layer.

Examples of thermoplastic resins that may be used in the base (X) include: polyolefin resins such as polyethylene and polypropylene; polyester resins such as polyethylene terephthalate (PET), polyethylene-2,6-naphthalate, polybutylene terephthalate, and copolymers thereof; polyamide resins such as nylon-6, nylon-66, and nylon-12; hydroxy group-containing polymers such as polyvinyl alcohol and ethylene-vinyl alcohol copolymer; polystyrene; poly(meth)acrylic acid ester; polyacrylonitrile; polyvinyl acetate; polycarbonate; polyarylate; regenerated cellulose; polyimide; polyetherimide; polysulfone; polyethersulfone; polyetheretherketone; and ionomer resins. When the multilayer structure is used as or in a packaging material, the material of the base (X) is preferably at least one thermoplastic resin selected from the group consisting of polyethylene, polypropylene, polyethylene terephthalate, nylon-6, and nylon-66.

When a film made of such a thermoplastic resin is used as the base (X), the base (X) may be an oriented film or non-oriented film. In terms of high suitability for processes (such as printing and lamination) of the resulting multilayer structure, an oriented film, in particular a biaxially-oriented film, is preferred. The biaxially-oriented film may be a biaxially-oriented film produced by any one method selected from simultaneous biaxial stretching, sequential biaxial stretching, and tubular stretching.

Examples of paper that may be used in the base (X) include kraft paper, high-quality paper, simili paper, glassine paper, parchment paper, synthetic paper, white paperboard, manila board, milk carton board, cup paper, and ivory paper. The use of paper in the base (X) makes it possible to obtain a multilayer structure for a paper container.

The inorganic deposited layer preferably has barrier properties against oxygen or water vapor and more preferably further has transparency. The inorganic deposited layer used as the base (X) or the inorganic deposited layer (X') that the base (X) may include in addition to the thermoplastic resin film layer can be formed by vapor deposition of an inorganic substance. Examples of the inorganic substance include metals (such as aluminum), metal oxides (such as aluminum oxide, silicon oxide, and magnesium oxide), metal nitrides (such as silicon nitride), metal oxynitrides (such as silicon oxynitride), and metal carbonitrides (such as silicon carbonitride). Among these, aluminum oxide, silicon oxide, magnesium oxide, and silicon nitride are preferred, since an inorganic deposited layer formed of any of these substances has good barrier properties against oxygen or water vapor.

### [Inorganic deposited layer (X')]

The thickness of the inorganic deposited layer (X') that the base (X) may include in addition to the thermoplastic resin film layer is preferably 0.002 to 0.5 µm, more preferably 0.005 to 0.2 µm, and even more preferably 0.01 to 0.1 µm, although the preferred thickness varies depending on the type of the substance forming the inorganic deposited layer (X'). A thickness at which good barrier properties or mechanical properties of the multilayer structure are achieved can be selected within the above range. If the thickness of the inorganic deposited layer (X') is less than 0.002 µm, the inorganic deposited layer (X') tends to have a low ability to repeatedly exhibit the barrier properties against oxygen or water vapor, and the inorganic deposited layer (X') may fail to exhibit sufficient barrier properties. If the thickness of the inorganic deposited layer (X') is more than 0.5 µm, the barrier properties of the inorganic deposited layer (X') are likely to deteriorate when the multilayer structure is pulled or bent.

The method for forming the inorganic deposited layer is not particularly limited, and available methods include: physical vapor deposition processes such as vacuum vapor deposition (e.g., resistive heating vapor deposition, electron beam vapor deposition, and molecular beam epitaxy), sputtering, and ion plating; and chemical vapor deposition processes such as thermal chemical vapor deposition (e.g., catalytic chemical vapor deposition), photochemical vapor deposition, plasma chemical vapor deposition (e.g., capacitively coupled plasma process, inductively coupled plasma process, surface wave plasma process, electron cyclotron resonance plasma process, and dual magnetron process), atomic layer deposition, and organometallic vapor deposition. The inorganic deposited layer (X') may be deposited on the layer (Y).

When the base (X) is in the form of a layer, the thickness of the base (X) is preferably 1 to 1,000 µm, more preferably 5 to 500 µm, and even more preferably 9 to 200 µm, in terms of high mechanical strength and good processability of the resulting multilayer structure.

### [Layer (Y)]

The layer (Y) contains the compound (A) and the polymer (BO). The layer (Y) preferably further contains the inorganic phosphorus compound (BI). The inorganic phosphorus compound (BI) and polymer (BO) have a phosphorus atom-containing functional group. The compound (A), the inorganic phosphorus compound (BI), and the polymer (BO) will be described hereinafter.

### [Aluminum-containing compound (A)]

The compound (A) may be an aluminum-containing metal oxide (Aa) or may be a compound (Ab) including a reaction product (D) formed by a reaction between the aluminum-containing metal oxide (Aa) (this metal oxide may be simply referred to as "metal oxide (Aa)" hereinafter) and the inorganic phosphorus compound (BI) (the compound including the reaction product (D) may be simply referred to as "compound (Ab)" hereinafter).

### [Aluminum-containing metal oxide (Aa)]

The aluminum-containing metal oxide (Aa) is typically in the form of particles when reacted with the inorganic phosphorus compound (BI).

Metal atoms (M) constituting the metal oxide (Aa) preferably have a valence of two or more. Examples of the metal atoms (M) include: atoms of metals of Group 2 of the periodic table such as magnesium and calcium; atoms of metals of Group 4 of the periodic table such as titanium and zirconium; atoms of metals of Group 12 of the periodic table such as zinc; atoms of metals of Group 13 of the periodic table such as boron and aluminum; and atoms of metals of Group 14 of the periodic table such as silicon. Boron and silicon are categorized herein as metals, although they may be classified as semimetals in other contexts. The metal atoms (M) may consist of single species of atoms or include two or more species of atoms. In terms of higher efficiency of production of the metal oxide (Aa) and better gas barrier properties and water vapor barrier properties of the resulting multilayer structure, the metal atoms (M) preferably include at least one species selected from the group consisting of aluminum atoms, titanium atoms, and zirconium atoms and more preferably consist of aluminum atoms. That is, it is preferable for the metal atoms (M) to include aluminum atoms.

The total proportion of aluminum atoms, titanium atoms, and zirconium atoms in the metal atoms (M) is typically 60 mol% or more and may be 100 mol%. The proportion of aluminum atoms in the metal atoms (M) is typically 50 mol% or more and may be 100 mol%. The metal oxide (Aa) is produced by a method such as liquid-phase synthesis, gas-phase synthesis, or solid grinding.

The metal oxide (Aa) may be a hydrolytic condensate of a compound (E) containing a metal atom (M) to which a hydrolyzable characteristic group is bonded (this compound may be simply referred to as "compound (E)" hereinafter). Examples of the characteristic group include R¹ in the general formula [I] described below. The hydrolytic condensate of the compound (E) can be regarded substantially as a metal oxide. Thus, the hydrolytic condensate of the compound (E) may be referred to as "metal oxide (Aa)" herein. That is, the term "metal oxide (Aa)" as used herein is interchangeable with the term "hydrolytic condensate of the compound (E)", while the term "hydrolytic condensate of the compound (E)" as used herein is interchangeable with the term "metal oxide (Aa)".

### [Compound (E) containing metal atom (M) to which hydrolyzable characteristic group is bonded]

In terms of ease of control of reaction with the inorganic phosphorus compound (BI) and in terms of good gas barrier properties of the resulting multilayer structure, the compound (E) preferably includes at least one compound (Ea) represented by the following general formula [I].

Al(R¹)ₖ(R²)₃₋ₖ [I]

In this formula, R¹ is a halogen atom (such as a fluorine atom, chlorine atom, bromine atom, or iodine atom), NO₃, an optionally substituted alkoxy group having 1 to 9 carbon atoms, an optionally substituted acyloxy group having 2 to 9 carbon atoms, an optionally substituted alkenyloxy group having 3 to 9 carbon atoms, an optionally substituted β-diketonato group having 5 to 15 carbon atoms, or a diacylmethyl group having an optionally substituted acyl group having 1 to 9 carbon atoms. R² is an optionally substituted alkyl group having 1 to 9 carbon atoms, an optionally substituted aralkyl group having 7 to 10 carbon atoms, an optionally substituted alkenyl group having 2 to 9 carbon atoms, or an optionally substituted aryl group having 6 to 10 carbon atoms. k is an integer of 1 to 3. When there are two or more atoms or groups represented by R¹, the atoms or groups represented by R¹ may be the same as or different from each other. When there are two or more groups represented by R², the groups represented by R² may be the same as or different from each other.

The compound (E) may include, in addition to the compound (Ea), at least one compound (Eb) represented by the following general formula [II].

M¹(R³)ₘ(R⁴)ₙ₋ₘ [II]

In this formula, M¹ is at least one metal atom different from an aluminum atom and selected from atoms of metals belonging to Groups 2 to 14 of the periodic table. R³ is a halogen atom (such as a fluorine atom, chlorine atom, bromine atom, or iodine atom), NO₃, an optionally substituted alkoxy group having 1 to 9 carbon atoms, an optionally substituted acyloxy group having 2 to 9 carbon atoms, an optionally substituted alkenyloxy group having 3 to 9 carbon atoms, an optionally substituted β-diketonato group having 5 to 15 carbon atoms, or a diacylmethyl group having an optionally substituted acyl group having 1 to 9 carbon atoms. R⁴ is an optionally substituted alkyl group having 1 to 9 carbon atoms, an optionally substituted aralkyl group having 7 to 10 carbon atoms, an optionally substituted alkenyl group having 2 to 9 carbon atoms, or an optionally substituted aryl group having 6 to 10 carbon atoms. m is an integer of 1 to n. n is equal to the valence of M¹. When there are two or more atoms or groups represented by R³, the atoms or groups represented by R³ may be the same as or different from each other. When there are two or more groups represented by R⁴, the groups represented by R⁴ may be the same as or different from each other.

Examples of the alkoxy groups represented by R¹ and R³ include methoxy, ethoxy, n-propoxy, isopropoxy, n-butoxy, isobutoxy, sec-butoxy, tert-butoxy, benzyloxy, diphenylmethoxy, trityloxy, 4-methoxybenzyloxy, methoxymethoxy, 1-ethoxyethoxy, benzyloxymethoxy, 2-trimethylsilylethoxy, 2-trimethylsilylethoxymethoxy, phenoxy, and 4-methoxyphenoxy groups.

Examples of the acyloxy groups represented by R¹ and R³ include acetoxy, ethylcarbonyloxy, n-propylcarbonyloxy, isopropylcarbonyloxy, n-butylcarbonyloxy, isobutylcarbonyloxy, sec-butylcarbonyloxy, tert-butylcarbonyloxy, and n-octylcarbonyloxy groups.

Examples of the alkenyloxy groups represented by R¹ and R³ include allyloxy, 2-propenyloxy, 2-butenyloxy, 1-methyl-2-propenyloxy, 3-butenyloxy, 2-methyl-2-propenyloxy, 2-pentenyloxy, 3-pentenyloxy, 4-pentenyloxy, 1-methyl-3-butenyloxy, 1,2-dimethyl-2-propenyloxy, 1,1-dimethyl-2-propenyloxy, 2-methyl-2-butenyloxy, 3-methyl-2-butenyloxy, 2-methyl-3-butenyloxy, 3-methyl-3-butenyloxy, 1-vinyl-2-propenyloxy, and 5-hexenyloxy groups.

Examples of the β-diketonato groups represented by R¹ and R³ include 2,4-pentanedionato, 1,1,1-trifluoro-2,4-pentanedionato, 1,1,1,5,5,5-hexafluoro-2,4-pentanedionato, 2,2,6,6-tetramethyl-3,5-heptanedionato, 1,3-butanedionato, 2-methyl-1,3-butanedionato, 2-methyl-1,3-butanedionato, and benzoylacetonato groups.

Examples of the acyl groups of the diacylmethyl groups represented by R¹ and R³ include: aliphatic acyl groups having 1 to 6 carbon atoms such as formyl, acetyl, propionyl (propanoyl), butyryl (butanoyl), valeryl (pentanoyl), and hexanoyl groups; and aromatic acyl (aroyl) groups such as benzoyl and toluoyl groups.

Examples of the alkyl groups represented by R² and R⁴ include methyl, ethyl, n-propyl, isopropyl, n-butyl, isobutyl, sec-butyl, tert-butyl, n-pentyl, isopentyl, n-hexyl, isohexyl, 3-methylpentyl, 2-methylpentyl, 1,2-dimethylbutyl, cyclopropyl, cyclopentyl, and cyclohexyl groups.

Examples of the aralkyl groups represented by R² and R⁴ include benzyl and phenylethyl (phenethyl) groups.

Examples of the alkenyl groups represented by R² and R⁴ include vinyl, 1-propenyl, 2-propenyl, isopropenyl, 3-butenyl, 2-butenyl, 1-butenyl, 1-methyl-2-propenyl, 1-methyl-1-propenyl, 1-ethyl-1-ethenyl, 2-methyl-2-propenyl, 2-methyl-1-propenyl, 3-methyl-2-butenyl, and 4-pentenyl groups.

Examples of the aryl groups represented by R² and R⁴ include phenyl, 1-naphthyl, and 2-naphthyl groups.

Examples of the substituents in R¹, R², R³, and R⁴ include: alkyl groups having 1 to 6 carbon atoms; alkoxy groups having 1 to 6 carbon atoms such as methoxy, ethoxy, n-propoxy, isopropoxy, n-butoxy, isobutoxy, sec-butoxy, tert-butoxy, n-pentyloxy, isopentyloxy, n-hexyloxy, cyclopropyloxy, cyclobutyloxy, cyclopentyloxy, and cyclohexyloxy groups; alkoxycarbonyl groups having 1 to 6 carbon atoms such as methoxycarbonyl, ethoxycarbonyl, n-propoxycarbonyl, isopropoxycarbonyl, n-butoxycarbonyl, isobutoxycarbonyl, sec-butoxycarbonyl, tert-butoxycarbonyl, n-pentyloxycarbonyl, isopentyloxycarbonyl, cyclopropyloxycarbonyl, cyclobutyloxycarbonyl, and cyclopentyloxycarbonyl groups; aromatic hydrocarbon groups such as phenyl, tolyl, and naphthyl groups; halogen atoms such as fluorine, chlorine, bromine, and iodine atoms; acyl groups having 1 to 6 carbon atoms; aralkyl groups having 7 to 10 carbon atoms; aralkyloxy groups having 7 to 10 carbon atoms; alkylamino groups having 1 to 6 carbon atoms; and dialkylamino groups having an alkyl group having 1 to 6 carbon atoms.

It is preferable for R¹ and R³ to be a halogen atom, NO₃, an optionally substituted alkoxy group having 1 to 6 carbon atoms, an optionally substituted acyloxy group having 2 to 6 carbon atoms, an optionally substituted β-diketonato group having 5 to 10 carbon atoms, or a diacylmethyl group having an optionally substituted acyl group having 1 to 6 carbon atoms, and it is more preferable for R¹ and R³ to be an optionally substituted alkoxy group having 1 to 6 carbon atoms.

It is preferable for R² and R⁴ to be an optionally substituted alkyl group having 1 to 6 carbon atoms. It is preferable for k in the formula [I] to be 3.

It is preferable for M¹ to be an atom of a metal belonging to Group 4 of the periodic table, and it is more preferable for M¹ to be titanium or zirconium. When M¹ is an atom of a metal belonging to Group 4 of the periodic table, m in the formula [II] is preferably 4.

Examples of the compound (Ea) include aluminum chloride, aluminum nitrate, aluminum acetate, tris(2,4-pentanedionato)aluminum, trimethoxyaluminum, triethoxyaluminum, tri-n-propoxyaluminum, triisopropoxyaluminum, tri-n-butoxyaluminum, tri-sec-butoxyaluminum, and tri-tert-butoxyaluminum. Among these, triisopropoxyaluminum and tri-sec-butoxyaluminum are preferred. A combination of two or more compounds (Ea) may be used as the compound (E).

Examples of the compound (Eb) include: titanium compounds such as tetrakis(2,4-pentanedionato)titanium, tetramethoxytitanium, tetraethoxytitanium, tetraisopropoxytitanium, tetra-n-butoxytitanium, and tetrakis(2-ethylhexoxy)titanium; and zirconium compounds such as tetrakis(2,4-pentanedionato)zirconium, tetra-n-propoxyzirconium, and tetra-n-butoxyzirconium. These may be used alone, or a combination of two or more thereof may be used as the compound (Eb).

The proportion of the compound (Ea) in the total amount of the compound (E) is not particularly limited as long as the effect of the present invention is obtained. The proportion of the compound (e.g., the compound (Eb)) other than the compound (Ea) in the total amount of the compound (E) is preferably, for example, 20 mol% or less, more preferably 10 mol% or less, and even more preferably 5 mol% or less, and may be 0 mol%.

The compound (E) is hydrolyzed, so that at least some of the hydrolyzable characteristic groups of the compound (E) are converted to hydroxy groups. The hydrolysate is then condensed to form a compound in which the metal atoms (M) are linked together via an oxygen atom (O). The repetition of this condensation results in the formation of a compound that can be regarded substantially as a metal oxide. The thus formed metal oxide (Aa), in general, has hydroxy groups present on its surface.

A compound is categorized herein as the metal oxide (Aa) when the ratio, [the number of moles of the oxygen atoms (O) bonded only to the metal atoms (M)]/[the number of moles of the metal atoms (M)], is 0.8 or more in the compound. The "oxygen atom (O) bonded only to the metal atom (M)", as defined herein, refers to the oxygen atom (O) in the structure represented by M-O-M, and does not include an oxygen atom that is bonded to both the metal atom (M) and hydrogen atom (H) as is the case for the oxygen atom (O) in the structure represented by M-O-H. The above ratio in the metal oxide (Aa) is preferably 0.9 or more, more preferably 1.0 or more, and even more preferably 1.1 or more. The upper limit of this ratio is not particularly defined. When the valence of the metal atom (M) is denoted by n, the upper limit is typically expressed as n/2.

In order for the hydrolytic condensation to take place, it is important that the compound (E) has hydrolyzable characteristic groups. When there are no such groups bonded, hydrolytic condensation reaction does not occur or proceeds very slowly, which makes difficult the preparation of the metal oxide (Aa) intended.

The hydrolytic condensate of the compound (E) may be produced, for example, from a particular starting material by a technique employed in known sol-gel processes. As the starting material there can be used at least one selected from the group consisting of the compound (E), a partial hydrolysate of the compound (E), a complete hydrolysate of the compound (E), a compound formed by partial hydrolytic condensation of the compound (E), and a compound formed by condensation of a part of a complete hydrolysate of the compound (E).

The metal oxide (Aa) to be mixed with an inorganic phosphorus compound (BI)-containing material (the inorganic phosphorus compound (BI) itself or a composition containing the inorganic phosphorus compound (BI)) is preferably substantially free of phosphorus atoms.

### [Compound (Ab)]

The reaction product (D) included in the compound (Ab) is obtained by a reaction between the metal oxide (Aa) and the inorganic phosphorus compound (BI). A compound formed by a reaction among the metal oxide (Aa), the inorganic phosphorus compound (BI), and another compound is also categorized as the reaction product (D). The compound (Ab) may partially include the metal oxide (Aa) and/or inorganic phosphorus compound (BI) that remains uninvolved in any reaction.

In the compound (Ab), the molar ratio between the metal atoms constituting the metal oxide (Aa) and the phosphorus atoms derived from the inorganic phosphorus compound (BI), as expressed by [Metal atoms constituting metal oxide (Aa)] : [Phosphorus atoms derived from inorganic phosphorus compound (BI)], is preferably 1.0 : 1.0 to 3.6 : 1.0, more preferably 1.01 : 1.00 to 1.50 : 1.00, and even more preferably 1.05 : 1.00 to 1.45 : 1.00. When the molar ratio is in such a range, the gas barrier performance is further improved. The molar ratio in the compound (Ab) can be controlled by adjusting the mixing ratio between the metal oxide (Aa) and the inorganic phosphorus compound (BI) in a coating liquid for forming the compound (Ab). The molar ratio in the compound (Ab) is typically equal to that in the coating liquid (S).

### [Infrared absorption spectrum of layer (Y)]

In an infrared absorption spectrum of the layer (Y), a maximum absorption wavenumber in the region from 800 to 1,400 cm⁻¹ is preferably 1,080 to 1,130 cm⁻¹. In the process in which the metal oxide (Aa) and the inorganic phosphorus compound (BI) react to form the reaction product (D), a metal atom (M) derived from the metal oxide (Aa) and a phosphorus atom (P) derived from the inorganic phosphorus compound (BI) are linked via an oxygen atom (O) to form a bond represented by M-O-P. As a result, a characteristic absorption band attributed to this bond appears in an infrared absorption spectrum of the reaction product (D). A study by the present inventors has revealed that the resulting multilayer structure exhibits good gas barrier properties when the characteristic absorption band attributed to the M-O-P bond is observed in the region from 1,080 to 1,130 cm⁻¹. It has also been found that the resulting multilayer structure exhibits much better gas barrier properties particularly when the characteristic absorption band corresponds to the strongest absorption in the region from 800 to 1,400 cm⁻¹ where absorptions attributed to bonds between various atoms and oxygen atoms are generally observed.

By contrast, if a metal compound such as a metal alkoxide or metal salt and the inorganic phosphorus compound (BI) are first mixed together and the mixture is then subjected to hydrolytic condensation, the resulting product is a composite material in which the metal atoms derived from the metal compound and the phosphorus atoms derived from the inorganic phosphorus compound (BI) have been almost homogeneously mixed and reacted. In this case, in an infrared absorption spectrum of the composite material, the maximum absorption wavenumber in the region from 800 to 1,400 cm⁻¹ falls outside the range of 1,080 to 1,130 cm⁻¹.

In the infrared absorption spectrum of the layer (Y), the width at half maximum of the maximum absorption band in the region from 800 to 1,400 cm⁻¹ is preferably 200 cm⁻¹ or less, more preferably 150 cm⁻¹ or less, even more preferably 100 cm⁻¹ or less, and particularly preferably 50 cm⁻¹ or less, in terms of the gas barrier properties of the resulting multilayer structure.

The infrared absorption spectrum of the layer (Y) can be measured by the method described in "EXAMPLES" below. If the measurement is not possible by the method described in "EXAMPLES", the measurement may be conducted by another method, examples of which include, but are not limited to: reflection spectroscopy such as reflection absorption spectroscopy, external reflection spectroscopy, or attenuated total reflection spectroscopy; and transmission spectroscopy such as Nujol method or pellet method performed on the layer (Y) scraped from the multilayer structure.

The compound (Ab) may have a structure in which particles of the metal oxide (Aa) are bonded together via phosphorus atoms derived from the inorganic phosphorus compound (BI). The particles of the metal oxide (Aa) which are used as a starting material for formation of the compound (Ab) may change in shape or size during the process of the formation of the compound (Ab).

### [Inorganic phosphorus compound (BI)]

The inorganic phosphorus compound (BI) has a moiety capable of reacting with the metal oxide (Aa) and typically has two or more such moieties. It is preferable for the inorganic phosphorus compound (BI) to be a compound having 2 to 20 such moieties (atomic groups or functional groups). Examples of such moieties include a moiety capable of undergoing a condensation reaction with a functional group (e.g., hydroxy group) present on the surface of the metal oxide (Aa). Examples of such a moiety include a halogen atom bonded directly to a phosphorus atom and an oxygen atom bonded directly to a phosphorus atom. In general, the functional group (e.g., hydroxy group) present on the surface of the metal oxide (Aa) is bonded to the metal atom (M) constituting the metal oxide (Aa).

Examples of the inorganic phosphorus compound (BI) include: phosphorus oxoacids such as phosphoric acid, diphosphoric acid, triphosphoric acid, polyphosphoric acid formed by condensation of 4 or more molecules of phosphoric acid, phosphorous acid, phosphonic acid, phosphonous acid, phosphinic acid, and phosphinous acid; salts of these oxoacids (e.g., sodium phosphate); and derivatives of these oxoacids (e.g., halides such as phosphoryl chloride and dehydration products such as phosphorus pentoxide).

These inorganic phosphorus compounds (BI) may be used alone or in combination with one another. Among these inorganic phosphorus compounds (BI), phosphoric acid is preferably used alone or in combination with another inorganic phosphorus compound (BI). The use of phosphoric acid improves the stability of the coating liquid (S) described later and the gas barrier properties of the resulting multilayer structure. When phosphoric acid is used in combination with another inorganic phosphorus compound (BI), phosphoric acid preferably makes up 50 mol% or more of the total inorganic phosphorus compounds (BI).

### [Polymer (BO) having phosphonic acid unit]

The polymer (BO) is a polymer having a phosphonic acid unit and is preferably a homopolymer or a copolymer of an alkenylphosphonic acid. The alkenylphosphonic acid is phosphonic acid substituted with an alkenyl group and is represented by the following general formula [III].

R⁵⁻P(=O)(OH)₂ [III]

In this formula, R⁵ is an optionally substituted alkenyl group having 2 to 30 (e.g., 2 to 10) carbon atoms. The alkenyl group may contain one or more oxycarbonyl groups in the carbon chain, and a part of the carbon chain may form a carbocyclic ring.

Examples of the alkenyl group include hydrocarbon chains having a carbon-carbon double bond, such as vinyl, allyl, 1-propenyl, isopropenyl, 2-methyl-1-propenyl, 2-methyl-2-propenyl, 1-butenyl, 2-butenyl, 3-butenyl, 1-pentenyl, 1-hexenyl, 1,3-hexadienyl, and 1,5-hexadienyl groups. Examples of the carbocyclic ring of the alkenyl group include benzene, naphthalene, cyclopropane, cyclobutane, cyclopentane, cyclopropene, cyclobutene, and cyclopentene rings. One or more saturated hydrocarbon chains such as methyl, ethyl, and propyl groups may be bonded to the carbocyclic ring in addition to the hydrocarbon chain having a carbon-carbon double bond.

Examples of the alkenylphosphonic acid monomer that can be suitably used in the present invention include: alkenylphosphonic acids such as vinylphosphonic acid and 2-propene-1-phosphonic acid; and alkenyl aromatic phosphonic acids such as 4-vinylbenzylphosphonic acid and 4-vinylphenylphosphonic acid. Among these, alkenylphosphonic acids are preferred, and vinylphosphonic acid is more preferred.

The polymer (BO) may consist of phosphonic acid units or may further contain other monomer units. The proportion of the phosphonic acid units in the total structural units of the polymer (BO) may be 50 to 100 mol% or may be 80 to 100 mol%.

The polymer (BO) can be obtained by polymerization of at least one monomer including a phosphonic acid. The polymer (BO) may be a copolymer of a phosphonic acid and another vinyl monomer. Examples of the other vinyl monomer copolymerizable with a phosphonic acid include (meth)acrylic acid, (meth)acrylic acid esters, (meth)acrylonitrile, styrene, nuclear-substituted styrenes, alkylvinyl ethers, alkylvinyl esters, perfluoroalkylvinyl ethers, perfluoroalkylvinyl esters, maleic acid, maleic anhydride, fumaric acid, itaconic acid, maleimide, and phenylmaleimide. Among these, (meth)acrylic acid esters, acrylonitrile, styrene, maleimide, and phenylmaleimide are preferred.

Examples of the polymer (BO) include poly(vinylphosphonic acid) and vinylphosphonic acid-methacrylic acid copolymer. Among these, poly(vinylphosphonic acid) is preferred because its use can lead to high antistatic performance. The molecular weight of the polymer (BO) is not particularly limited, and the number-average molecular weight of the polymer (BO) may be 5,000 to 100,000.

The antistatic sheet of the present invention exhibits high antistatic performance due to the layer (Y) having a surface electrical resistivity of 1.0 × 10⁶ Ω/sq or more and 4.0 × 10¹³ Ω/sq or less. The surface electrical resistivity of the layer (Y) may be 1.0 × 10⁶ Ω/sq or more and 3.0 × 10¹² Ω/sq or less.

The antistatic performance can be further improved when some of the phosphonic acid units in the polymer (BO) react with aluminum atoms in the compound (A). The Pauling's electronegativity is 2.29 for phosphorus atoms, 3.44 for oxygen atoms, 2.20 for hydrogen atoms, and 1.61 for aluminum atoms. The difference in electronegativity between oxygen atoms and hydrogen atoms is 1.24, and the difference in electronegativity between oxygen atoms and aluminum atoms is 1.83. Thus, reaction of some of phosphonic acid groups in the polymer (BO) with aluminum atoms in the compound (A) further biases the distribution of electric charges, thus increasing the electrical conductivity (namely, reducing the electrical resistance). The above values of the Pauling's electronegativity of the various atoms are those cited from Table 3 of the following Reference Document 1.

Reference Document 1: A. L. Allred, Journal of Inorganic and Nuclear Chemistry, vol. 17, pp. 215-221 (1961)

The mechanism by which the features of the present invention produce an antistatic effect has not yet been elucidated.

The surface electrical resistivity of the layer (Y) can be increased or reduced depending on the polarity of the molecules constituting the layer (Y). The increase in the surface electrical resistivity of the layer (Y) can be achieved, for example, by reducing the amount of phosphonic acid units in the polymer (BO) or by adding a nonionic compound (such as polyvinyl alcohol) to the layer (Y). The reduction in the surface electrical resistivity of the layer (Y) can be achieved by replacing the phosphonic acid by a phosphonic acid salt (such as sodium vinylphosphonate) in polymerization for forming the polymer (BO). Addition of an ionic compound (such as a quaternary ammonium salt) to the layer (Y) can also reduce the surface electrical resistivity of the layer (Y). Increasing the amount of phosphonic acid units in the polymer (BO) can also result in a reduction in the surface electrical resistivity of the layer (Y).

When the layer (Y) of the multilayer structure contains the inorganic phosphorus compound (BI) and the polymer (BO), the ratio W_{BO}/W_{BI} between the weight W_{BI} of the inorganic phosphorus compound (BI) and the weight W_{BO} of the polymer (BO) in the layer (Y) is less than 0.32. To achieve better water vapor barrier properties, the ratio W_{BO}/W_{BI} is more preferably less than 0.26 and even more preferably less than 0.14. The ratio W_{BO}/W_{BI} is preferably more than 0.0001. To achieve better gas barrier properties and better water vapor barrier properties, the ratio W_{BO}/W_{BI} is more preferably more than 0.001, even more preferably more than 0.01, and particularly preferably more than 0.04.

The layer (Y) included in the multilayer structure of the present invention may consist of the aluminum-containing compound (A) and the polymer (BO), may consist of the aluminum-containing compound (A), the inorganic phosphorus compound (BI), and the polymer (BO), may consist of the aluminum-containing metal oxide (Aa), the inorganic phosphorus compound (BI), and the polymer (BO), may consist of the inorganic phosphorus compound (BI), the polymer (BO), and the compound (Ab) including the reaction product (D) of the aluminum-containing metal oxide (Aa) and the inorganic phosphorus compound (BI), or may consist of the aluminum-containing metal oxide (Aa), the inorganic phosphorus compound (BI), the polymer (BO), and the compound (Ab) including the reaction product (D) of the aluminum-containing metal oxide (Aa) and the inorganic phosphorus compound (BI). In all of the above aspects, the layer (Y) can further contain an additional component. Examples of the additional component that may be contained in the layer (Y) include: metal salts of inorganic acids such as a metal carbonate, a metal hydrochloride, a metal nitrate, a metal hydrogen carbonate, a metal sulfate, a metal hydrogen sulfate, and a metal borate; metal salts of organic acids such as a metal oxalate, a metal acetate, a metal tartrate, and a metal stearate; metal complexes such as a cyclopentadienyl metal complex (e.g., titanocene) and a cyanometal complex (e.g., Prussian blue); layered clay compounds; crosslinkers; a polymer other than the polymer (BO) (the polymer other than the polymer (BO) may be simply referred to as "polymer (F)" hereinafter); plasticizers; antioxidants; ultraviolet absorbers; and flame retardants. The content of the additional component in the layer (Y) of the multilayer structure is preferably 50 wt% or less, more preferably 20 wt% or less, even more preferably 10 wt% or less, and particularly preferably 5 wt% or less, and may be 0 wt% (which means that the additional component is not contained).

### [Polymer (F)]

The polymer (F) may be a polymer (Fa) having at least one functional group selected from the group consisting of an ether bond, a carbonyl group, a hydroxy group, a carboxyl group, a carboxylic anhydride group, and a salt of a carboxyl group.

Examples of the polymer (Fa) include: polyethylene glycol; polyketone; polyvinyl alcohol polymers such as polyvinyl alcohol, modified polyvinyl alcohol containing 1 to 50 mol% of α-olefin units having 4 or less carbon atoms, and polyvinyl acetal (e.g., polyvinyl butyral); polysaccharides such as cellulose, starch, and cyclodextrin; (meth)acrylic polymers such as polyhydroxyethyl (meth)acrylate, poly(meth)acrylic acid, and ethylene-acrylic acid copolymer; and maleic polymers such as a hydrolysate of ethylene-maleic anhydride copolymer, a hydrolysate of styrene-maleic anhydride copolymer, and a hydrolysate of isobutylene-maleic anhydride alternating copolymer. To allow the layer (Y) to have high transparency, it is preferable not to incorporate any of the polyvinyl alcohol polymers.

The polymer (Fa) may be a homopolymer of a monomer having a polymerizable group (e.g., vinyl acetate or acrylic acid), may be a copolymer of two or more monomers, or may be a copolymer of a monomer having a hydroxy group and/or carboxyl group and a monomer having neither of these groups. A combination of two or more polymers (Fa) may be used as the polymer (Fa).

The molecular weight of the polymer (Fa) is not particularly limited. In order to obtain a multilayer structure that has better gas barrier properties and higher mechanical strength, the number-average molecular weight of the polymer (Fa) is preferably 5,000 or more, more preferably 8,000 or more, and even more preferably 10,000 or more. The upper limit of the number-average molecular weight of the polymer (Fa) is not particularly defined, and the number-average molecular weight is, for example, 1,500,000 or less.

In terms of allowing the multilayer structure to hold good appearance, the content of the polymer (Fa) in the layer (Y) is preferably 85 wt% or less, more preferably 50 wt% or less, even more preferably 20 wt% or less, and particularly preferably 10 wt% or less, with respect to the weight of the layer (Y) (defined as 100 wt%). The polymer (Fa) may or may not react with another component in the layer (Y).

The thickness of the layer (Y) (or, for a multilayer structure including two or more layers (Y), the total thickness of the layers (Y)) is preferably 0.05 to 4.0 µm, more preferably 0.1 to 2.0 µm, and even more preferably 0.2 to 0.8 µm. Thinning the layer (Y) provides a reduction in the dimensional change of the multilayer structure during a process such as printing or lamination. Thinning the layer (Y) also provides an increase in the flexibility of the multilayer structure, thus making it possible to allow the multilayer structure to have mechanical characteristics close to mechanical characteristics intrinsic to the base. When the multilayer structure of the present invention includes two or more layers (Y), the thickness of each layer (Y) is preferably 0.05 µm or more in terms of gas barrier properties. The thickness of the layer (Y) can be controlled depending on the concentration of the later-described coating liquid (S) used for formation of the layer (Y) or the method for applying the liquid (S).

The thickness of the layer (Y) can be measured by observing a cross-section of the multilayer structure with a scanning electron microscope or transmission electron microscope.

### [Method for producing multilayer structure]

An exemplary method for producing the multilayer structure of the present invention will be described hereinafter. The features described for the multilayer structure of the present invention can be applied to the production method of the present invention and may not be described repeatedly. The features described for the production method of the present invention can be applied to the multilayer structure of the present invention.

An example of the method for producing the multilayer structure of the present invention is a production method including the steps of: (i) forming a precursor layer; (ii) applying a coating liquid (T) containing the polymer (BO); and (iii) forming a gas barrier layer (Y). The compound (A), the inorganic phosphorus compound (BI), the polymer (BO), and the weight ratio between them are as previously described, and repeated explanation will be omitted in the following description of the production method.

### [Step (i)]

In the step (i), a coating liquid (S) containing the aluminum-containing compound (A) is applied onto the base (X) to form a precursor layer of the layer (Y) on the base (X). The step (i) results in a structure including the base (X) and the precursor layer of the layer (Y). When the layer (Y) should contain a deposited layer (Ac) of aluminum or a deposited layer (Ad) of aluminum oxide, such a deposited layer can be formed by any of the common vapor deposition processes mentioned above. Thus, the following will give a detailed description of a method for forming a precursor layer of the layer (Y) containing the compound (Ab).

In a preferred embodiment, the coating liquid (S) (first coating liquid) can be prepared by mixing the metal oxide (Aa) and the inorganic phosphorus compound (BI) in a solvent to cause a reaction. Specifically, the coating liquid (S) can be prepared, for example, by a method in which a dispersion of the metal oxide (Aa) and a solution containing the inorganic phosphorus compound (BI) are mixed or by a method in which the inorganic phosphorus compound (BI) is added to and mixed with a dispersion of the metal oxide (Aa). The temperature during the mixing is preferably 50°C or lower, more preferably 30°C or lower, and even more preferably 20°C or lower. The coating liquid (S) may contain another compound (e.g., the polymer (F)). The coating liquid (S) may, if desired, contain at least one acid compound (Q) selected from the group consisting of acetic acid, hydrochloric acid, nitric acid, trifluoroacetic acid, and trichloroacetic acid.

The dispersion of the metal oxide (Aa) can be prepared, for example, by mixing the compound (E), water, and optionally an acid catalyst or organic solvent and allowing the compound (E) to undergo condensation or hydrolytic condensation according to procedures employed in known sol-gel processes. When the dispersion of the metal oxide (Aa) is obtained by condensation or hydrolytic condensation of the compound (E), the dispersion obtained may, if desired, be subjected to a certain process (such as deflocculation in the presence of the acid compound (Q)). The solvent used is preferably, but not limited to, an alcohol such as methanol, ethanol, or isopropanol, water, or a mixed solvent thereof.

The solution containing the inorganic phosphorus compound (BI) can be prepared by dissolving the inorganic phosphorus compound (BI) in a solvent. The solvent can be selected depending on the type of the inorganic phosphorus compound (BI), and preferably contains water. The solvent may contain an organic solvent (e.g., an alcohol such as methanol) as long as the organic solvent does not hinder the dissolution of the inorganic phosphorus compound (BI).

The solids concentration in the coating liquid (S) is preferably 1 to 20 wt%, more preferably 2 to 15 wt%, and even more preferably 3 to 10 wt%, in terms of the storage stability of the coating liquid and the quality of application of the coating liquid onto the base (X). The solids concentration can be determined, for example, by distilling off the solvent from the coating liquid (S) and dividing the weight of the remaining solids by the initial weight of the coating liquid (S) yet to be subjected to the distillation.

The viscosity of the coating liquid (S) is preferably 3,000 mPa•s or less, more preferably 2,500 mPa•s or less, and even more preferably 2,000 mPa•s or less, as measured with a Brookfield rotary viscometer (SB-type viscometer: rotor No. 3, rotational speed = 60 rpm) at a temperature at which the coating liquid (S) is applied. Adjusting the viscosity to 3,000 mPa•s or less improves the leveling of the coating liquid (S), thus allowing the resulting multilayer structure to have better appearance. The viscosity of the coating liquid (S) is preferably 50 mPa•s or more, more preferably 100 mPa•s or more, and even more preferably 200 mPa•s or more.

The molar ratio between aluminum atoms and phosphorus atoms in the coating liquid (S), as expressed by aluminum atoms : phosphorus atoms, is preferably, but not limited to, 1.0 : 1.0 to 3.6 : 1.0, more preferably 1.01 : 1.00 to 1.50 : 1.00, and even more preferably 1.05 : 1.00 to 1.45 : 1.00. The molar ratio between aluminum atoms and phosphorus atoms can be determined by fluorescent X-ray analysis of a solid obtained by drying the coating liquid (S).

The coating liquid (S) may be applied directly onto at least one surface of the base (X) or applied onto the base (X) with an additional layer (J) interposed therebetween. An adhesive layer (I) may be formed on a surface of the base (X) by treating the surface of the base (X) with a known anchor coating agent or applying a known adhesive onto the surface of the base (X) before application of the coating liquid (S).

The method for application of the coating liquid (S) is not particularly limited, and any known method can be employed. Examples of the method for application include casting, dipping, roll coating, gravure coating, screen printing, reverse coating, spray coating, kiss coating, die coating, metering bar coating, chamber doctor-using coating, curtain coating, and bar coating.

In the step (i), the precursor layer of the layer (Y1) is formed typically by removing the solvent from the coating liquid (S). The method for removing the solvent is not particularly limited, and any known drying method can be employed. Examples of the drying method include hot air drying, hot roll contact drying, infrared heating, and microwave heating. The drying temperature is preferably equal to or lower than the onset temperature of fluidization of the base (X). The temperature employed for drying the applied coating liquid (S) may be, for example, around 80 to 180°C or around 90 to 150°C. The drying time is preferably, but not limited to, 0.1 seconds to 1 hour, more preferably 1 second to 15 minutes, and even more preferably 5 to 300 seconds, for example. The drying is preferably followed by heat treatment. The heat treatment temperature may be, for example, around 100 to 200°C or around 120 to 180°C, and is preferably higher than the drying temperature. The heat treatment time is preferably, but not limited to, 1 second to 1 hour, more preferably 1 second to 15 minutes, and even more preferably 5 to 300 seconds, for example. Such a heat treatment prior to application of the coating liquid (T) containing the polymer (BO) is preferred to obtain a multilayer structure having good properties.

### [Step (ii)]

In the step (ii), the coating liquid (T) containing the polymer (BO) is applied onto the precursor layer of the layer (Y) which has been obtained in the step (i).

The coating liquid (T) (second coating liquid) can be prepared by mixing the polymer (BO) and a solvent. The coating liquid (T) thus prepared is applied onto the precursor layer of the layer (Y) which has been obtained in the step (i).

The solvent used in the coating liquid (T) can be selected as appropriate depending on the type of the polymer (BO) and is preferably, but not limited to, an alcohol such as methanol, ethanol, or isopropanol, water, or a mixed solvent thereof.

The concentration of solids of the polymer (BO) in the coating liquid (T) is preferably 0.01 to 10 wt%, more preferably 0.1 to 9 wt%, and even more preferably 0.2 to 5 wt% in terms of the storage stability of the coating liquid or the quality of application of the coating liquid. The solids concentration can be determined by the same method as described for the coating liquid (S). The coating liquid (T) may contain another component (e.g., the polymer (F)) that may be contained in the layer (Y) described above, as long as the effect of the present invention is obtained.

The application of the coating liquid (T) is followed by removal of the solvent, resulting in the formation of the precursor layer of the layer (Y). As is the case for application of the coating liquid (S), the method for applying the coating liquid (T) is not particularly limited, and any known method can be employed. When the inorganic phosphorus compound (BI) is used, it is particularly preferable to adjust the amount of the coating liquid (T) to be applied so that the ratio W_{BO}/W_{BI} between the weight W_{BI} of the inorganic phosphorus compound (BI) and the weight W_{BO} of the polymer (BO) satisfies the predetermined condition described above.

The method for removing the solvent from the coating liquid (T) is not particularly limited, and any known drying method can be employed. Examples of the drying method include hot air drying, hot roll contact drying, infrared heating, and microwave heating. The drying temperature is preferably equal to or lower than the onset temperature of fluidization of the base (X). The temperature employed for drying the applied coating liquid (T) may be, for example, around 90 to 240°C, and is preferably 100 to 200°C.

### [Step (iii)]

In the step (iii), the precursor layer of the layer (Y), which has been formed through the steps (i) and (ii), is heat-treated at a temperature of 140°C or higher to form the layer (Y). The heat treatment temperature is preferably higher than the temperature employed for drying the applied coating liquid (T).

In the step (iii), a reaction takes place in which particles of the metal oxide (Aa) are bonded together via phosphorus atoms (phosphorus atoms derived from the inorganic phosphorus compound (BI)). From another standpoint, a reaction of formation of the reaction product (D) takes place in the step (iii). To allow the reaction to take place to a sufficient extent, the heat treatment temperature is 140°C or higher, preferably 170°C or higher, more preferably 180°C or higher, and even more preferably 190°C or higher. A lowered heat treatment temperature increases the time required to achieve a sufficient reaction rate, thereby causing a reduction in production efficiency. The preferred upper limit of the heat treatment temperature depends on, for example, the type of the base (X). For example, when a thermoplastic resin film made of polyamide resin is used as the base (X), the heat treatment temperature is preferably 270°C or lower. When a thermoplastic resin film made of polyester resin is used as the base (X), the heat treatment temperature is preferably 240°C or lower. The heat treatment may be carried out, for example, in an air atmosphere, nitrogen atmosphere, or argon atmosphere. The heat treatment time is preferably 0.1 seconds to 1 hour, more preferably 1 second to 15 minutes, and even more preferably 5 to 300 seconds.

In a preferred embodiment of the method for producing a multilayer structure according to the present invention, the application of the coating liquid (S) is followed by drying (first drying) and then by heat treatment (first heat treatment) to form a precursor layer, and the application of the coating liquid (T) is followed by drying (second drying) and then by heat treatment (second heat treatment). It is preferable that the temperature of the first heat treatment be higher than the temperature of the first drying, the temperature of the second heat treatment be higher than the temperature of the second drying, and the temperature of the second heat treatment be higher than the temperature of the first heat treatment.

The multilayer structure thus obtained can be used per se as the antistatic sheet of the present invention. Another member (e.g., the adhesive layer (I) or the additional layer (J)) may be bonded to or formed on the multilayer structure obtained as above, and the resulting multilayer structure may be used as the antistatic sheet of the present invention. Such an antistatic sheet can be produced by a production method including the steps of the above-described method for producing a multilayer structure and further including the step of bonding or forming another member (e.g., the adhesive layer (I) or the additional layer (J)). The bonding of the other member can be accomplished by a known method.

### [Adhesive layer (I)]

In the multilayer structure of the present invention, the layer (Y) may be stacked in direct contact with the base (X). Alternatively, the layer (Y) may be stacked on the base (X), with the adhesive layer (I) interposed therebetween. The adhesion between the base (X) and the layer (Y) can be enhanced by means of the adhesive layer (I). The adhesive layer (I) may be made of an adhesive resin. The adhesive layer (I) made of an adhesive resin can be formed by treating a surface of the base (X) with a known anchor coating agent or applying a known adhesive onto the surface of the base (X). The adhesive is preferably a two-component reactive polyurethane adhesive including a polyisocyanate component and a polyol component which are to be mixed and reacted. Addition of a small amount of an additive such as a known silane coupling agent to the anchor coating agent or adhesive can further enhance the adhesion. Examples of the silane coupling agent include, but are not limited to, silane coupling agents having a reactive group such as an isocyanate, epoxy, amino, ureido, or mercapto group. Strong adhesion between the base (X) and layer (Y) via the adhesive layer (I) makes it possible to effectively prevent deterioration in the gas barrier properties or appearance of the multilayer structure of the present invention when the multilayer structure is subjected to a process such as printing or lamination, and also makes it possible to increase the drop impact resistance of a packaging material including the multilayer structure of the present invention. The thickness of the adhesive layer (I) is preferably 0.01 to 10.0 µm and more preferably 0.03 to 5.0 µm.

### [Additional layer (J)]

The multilayer structure of the present invention may further include the additional layer (J) for improving various properties (such as heat sealing properties, barrier properties, and mechanical properties). The multilayer structure of the present invention that includes the additional layer (J) can be produced, for example, by stacking the layer (Y) on the base (X) directly or with the adhesive layer (I) interposed therebetween and then by bonding or forming the additional layer (J) on the layer (Y) directly or with the adhesive layer (I) interposed therebetween. Examples of the additional layer (J) include, but are not limited to: ink layers; and thermoplastic resin layers such as a polyolefin layer and an ethylene-vinyl alcohol copolymer resin layer.

The multilayer structure of the present invention may include an ink layer on which a product name, decorative pattern, or the like is to be printed. The multilayer structure of the present invention that includes an ink layer can be produced, for example, by staking the layer (Y) on the base (X) directly or with the adhesive layer (I) interposed therebetween and then by forming the ink layer directly on the layer (Y). Examples of the ink layer include a film resulting from drying of a liquid prepared by dispersing a polyurethane resin containing a pigment (e.g., titanium dioxide) in a solvent. The ink layer may be a film resulting from drying of an ink or electronic circuit-forming resist containing a pigment-free polyurethane resin or another resin as a main component. Methods that can be used to apply the ink layer onto the layer (Y) include gravure printing and various coating methods using a wire bar, a spin coater, or a die coater. The thickness of the ink layer is preferably 0.5 to 10.0 µm and more preferably 1.0 to 4.0 µm.

Placing a polyolefin layer as an outermost layer of the multilayer structure of the present invention can impart heat-sealing properties to the multilayer structure or improve the mechanical characteristics of the multilayer structure. In terms of, for example, the impartation of heat-sealing properties and the improvement in mechanical characteristics, the polyolefin is preferably polypropylene or polyethylene. It is also preferable to stack at least one film selected from the group consisting of a film made of a polyester, a film made of a polyamide, and a film made of a hydroxy group-containing polymer, in order to improve the mechanical characteristics of the multilayer structure. In terms of the improvement in mechanical characteristics, the polyester is preferably polyethylene terephthalate, and the polyamide is preferably nylon-6. In terms of allowing all the layers to have barrier properties, the hydroxy group-containing polymer is preferably ethylene-vinyl alcohol copolymer. Between the layers there may, if desired, be provided an anchor coat layer or a layer made of an adhesive.

### [Configuration of multilayer structure]

Specific examples of the configuration of the multilayer structure of the present invention are listed below. The multilayer structure may include a member (e.g., the adhesive layer (I) or additional layer (J)) other than the base (X) and layer (Y); however, the other member is omitted in the following list of specific examples. The multilayer structures listed below as specific examples may be stacked on top of each other or combined with each other.
(1) Layer (Y)/polyester layer,
(2) Layer (Y)/polyester layer/layer (Y),
(3) Layer (Y)/polyamide layer,
(4) Layer (Y)/polyamide layer/layer (Y),
(5) Layer (Y)/polyolefin layer,
(6) Layer (Y)/polyolefin layer/layer (Y),
(7) Layer (Y)/hydroxy group-containing polymer layer,
(8) Layer (Y)/hydroxy group-containing polymer layer/layer (Y),
(9) Layer (Y)/paper layer,
(10) Layer (Y)/paper layer/layer (Y),
(11) Layer (Y)/inorganic deposited layer/polyester layer,
(12) Layer (Y)/inorganic deposited layer/polyamide layer,
(13) Layer (Y)/inorganic deposited layer/polyolefin layer,
(14) Layer (Y)/inorganic deposited layer/hydroxy group-containing polymer layer,
(15) Layer (Y)/polyester layer/polyamide layer/polyolefin layer,
(16) Layer (Y)/polyester layer/layer (Y)/polyamide layer/polyolefin layer,
(17) Polyester layer/layer (Y)/polyester layer/layer (Y)/inorganic deposited layer/hydroxy group-containing polymer layer/polyolefin layer,
(18) Polyester layer/layer (Y)/polyamide layer/polyolefin layer,
(19) Layer (Y)/polyamide layer/polyester layer/polyolefin layer,
(20) Layer (Y)/polyamide layer/layer (Y)/polyester layer/polyolefin layer,
(21) Polyamide layer/layer (Y)/polyester layer/polyolefin layer,
(22) Layer (Y)/polyolefin layer/polyamide layer/polyolefin layer,
(23) Layer (Y)/polyolefin layer/layer (Y)/polyamide layer/polyolefin layer,
(24) Polyolefin layer/layer (Y)/polyamide layer/polyolefin layer,
(25) Layer (Y)/polyolefin layer/polyolefin layer,
(26) Layer (Y)/polyolefin layer/layer (Y)/polyolefin layer,
(27) Polyolefin layer/layer (Y)/polyolefin layer,
(28) Layer (Y)/polyester layer/polyolefin layer,
(29) Layer (Y)/polyester layer/layer (Y)/polyolefin layer,
(30) Polyester layer/layer (Y)/polyolefin layer,
(31) Layer (Y)/polyamide layer/polyolefin layer,
(32) Layer (Y)/polyamide layer/layer (Y)/polyolefin layer,
(33) Polyamide layer/layer (Y)/polyolefin layer,
(34) Layer (Y)/polyester layer/paper layer,
(35) Layer (Y)/polyamide layer/paper layer,
(36) Layer (Y)/polyolefin layer/paper layer,
(37) Polyolefin layer/paper layer/polyolefin layer/layer (Y)/polyester layer/polyolefin layer,
(38) Polyolefin layer/paper layer/polyolefin layer/layer (Y)/polyamide layer/polyolefin layer,
(39) Polyolefin layer/paper layer/polyolefin layer/layer (Y)/polyolefin layer,
(40) Paper layer/polyolefin layer/layer (Y)/polyester layer/polyolefin layer,
(41) Polyolefin layer/paper layer/layer (Y)/polyolefin layer,
(42) Paper layer/layer (Y)/polyester layer/polyolefin layer,
(43) Paper layer/layer (Y)/polyolefin layer,
(44) Layer (Y)/paper layer/polyolefin layer,
(45) Layer (Y)/polyester layer/paper layer/polyolefin layer,
(46) Polyolefin layer/paper layer/polyolefin layer/layer (Y)/polyolefin layer/hydroxy group-containing polymer layer,
(47) Polyolefin layer/paper layer/polyolefin layer/layer (Y)/polyolefin layer/polyamide layer,
(48) Polyolefin layer/paper layer/polyolefin layer/layer (Y)/polyolefin layer/polyester layer,
(49) Inorganic deposited layer/layer (Y)/polyester layer,
(50) Inorganic deposited layer/layer (Y)/polyester layer/layer (Y)/inorganic deposited layer,
(51) Inorganic deposited layer/layer (Y)/polyamide layer,
(52) Inorganic deposited layer/layer (Y)/polyamide layer/layer (Y)/inorganic deposited layer,
(53) Inorganic deposited layer/layer (Y)/polyolefin layer,
(54) Inorganic deposited layer/layer (Y)/polyolefin layer/layer (Y)/inorganic deposited layer

The antistatic sheet of the present invention has a moisture permeability of 2.0 g/(m²•day) or less, preferably 0.50 g/(m²•day) or less, more preferably 0.30 g/(m²•day) or less, at 40°C and 90% RH. The method and conditions of the measurement of the moisture permeability are as described in "EXAMPLES" below.

The antistatic sheet of the present invention has an oxygen transmission rate of 2.0 mL/(m²•day•atm) or less, preferably 0.50 mL/(m²•day•atm) or less, more preferably 0.20 mL/(m²•day•atm) or less, at 20°C and 85% RH. The method and conditions of the measurement of the oxygen transmission rate are as described in "EXAMPLES" below.

### [Applications]

The antistatic sheet of the present invention has high gas barrier performance, high water vapor barrier performance, and antistatic performance. The antistatic sheet of the present invention can therefore be used in various applications, such as in packaging materials and in electronic devices.

### [Packaging material]

A packaging material of the present invention includes the antistatic sheet of the present invention. The packaging material including the antistatic sheet of the present invention can be used in various applications. This packaging material is preferred for use in applications that require antistatic performance in addition to barrier performance against oxygen and water vapor. For example, the packaging material according to the present invention is preferred for use as a packaging material for powdery substances such as dried bonito shavings and red pepper powder. The packaging material according to the present invention is preferred also for use as a packaging material for electronic components including ICs, transistors, diodes, capacitors, and piezoelectric resistors, as well as for use as a packaging material for foods.

The packaging material of the present invention can be fabricated by any of various known methods without any particular limitation. For example, a container (packaging material) may be fabricated by subjecting an antistatic sheet or a film material including the antistatic sheet (such a material may be simply referred to as "film material" hereinafter) to a joining process and thereby forming the antistatic sheet or the film material into a predetermined container shape. Examples of the method for shaping include thermoforming, injection molding, and extrusion blow molding. Alternatively, a container (packaging material) may be fabricated by forming the layer (Y) on the base (X) formed in a predetermined container shape. A container fabricated as described above may be referred to as a "packaging container" herein.

The packaging material including the antistatic sheet of the present invention may be used after being formed into any of various shaped products by secondary processing. Such a shaped product (packaging material) may be a vertical form-fill-seal bag, a vacuum packaging bag, a pouch, a laminated tube container, an infusion bag, a container lid, a paper container, or a vacuum insulator. These shaped products may be formed through heat sealing. Airborne matter such as dust cannot readily adhere to the antistatic sheet of the present invention, which reduces the likelihood of such airborne matter being caught in a heat-sealed portion.

### [Vertical form-fill-seal bag]

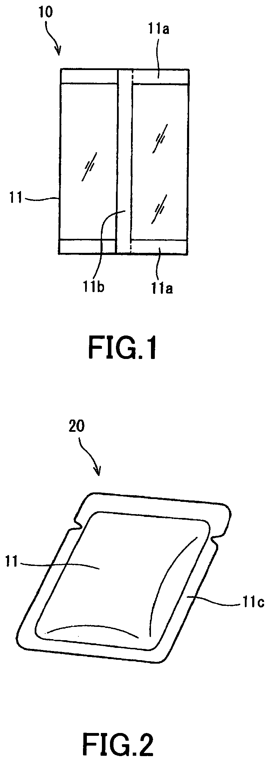

The packaging material of the present invention may be a vertical form-fill-seal bag. An example is shown in FIG. 1. A vertical form-fill-seal bag 10 shown in FIG. 1 is formed of an antistatic sheet 11 of the present invention which is sealed at three portions, namely, two edge portions 11a and a body portion 11b. The vertical form-fill-seal bag 10 can be produced by a vertical form-fill-seal machine. Various methods can be employed for bag making by a vertical form-fill-seal machine. In any method, the substance to be contained in the bag is fed through the top opening of the bag into its interior, and the opening is then sealed to produce the vertical form-fill-seal bag. The vertical form-fill-seal bag is composed of, for example, one film material heat-sealed at three portions, namely, its upper edge, lower edge, and side. The vertical form-fill-seal bag as the packaging container according to the present invention has good gas barrier properties and water vapor barrier properties. In addition, matter such as dust is less likely to adhere to the portions of the sheet which are to be bonded to make the bag. The use of the vertical form-fill-seal bag can therefore prevent quality degradation of the contained substance over a long period of time.

### [Pouch]

The packaging material of the present invention may be a pouch. An example is shown in FIG. 2. A flat pouch 20 of FIG. 2 is formed of two antistatic sheets 11 joined together at their edges 11c. The term "pouch" as used herein generally refers to a container including a film material as a barrier member and intended to contain a food, a daily commodity, or a medical product. Pouches can have various shapes and applications, and examples include a spouted pouch, a zippered pouch, a flat pouch, a stand-up pouch, a horizontal form-fill-seal pouch, and a retort pouch. Such a pouch may be formed by stacking a multilayer barrier film and at least another layer together. The pouch as the packaging container according to the present invention has good gas barrier properties and water vapor barrier properties. In addition, matter such as dust is less likely to adhere to the portions of the sheets which are to be bonded to make the pouch. The use of the pouch can therefore prevent quality degradation of the contained substance over a long period of time. An example of the pouch can hold good transparency, which allows easy identification of the contained substance and easy check for change in the quality of the contained substance caused by degradation.

### [Vacuum insulator]

A vacuum insulator is a heat insulator including a sheath material and a core material disposed in an interior bounded by the sheath material, and the interior in which the core material is disposed has a reduced pressure. A vacuum insulator thinner and lighter than an insulator made of urethane foam can provide heat insulating properties comparable to the heat insulating properties provided by the urethane foam insulator. The vacuum insulator of the present invention is capable of maintaining the heat-insulating effect over a long period of time and can therefore be used as or in: a heat insulating material for home electric appliances such as refrigerators, hot-water supply systems, and rice cookers; a residential heat insulating material used in walls, ceilings, attics, floors, etc.; a vehicle roof member; an insulating panel for automatic vending machines etc.; and a heat insulating material for heat transfer apparatuses such as an apparatus employing a heat pump.

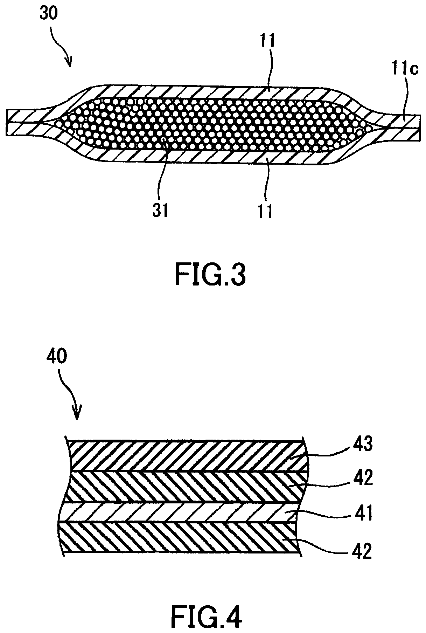

An example of the vacuum insulator according to the present invention is shown in FIG. 3. A vacuum insulator 30 of FIG. 3 includes a sheath material 11 and a core material 31 in the form of particles. The sheath material 11 is constituted by two film materials joined together at their edges 11c, and the core material 31 is disposed in an interior bounded by the sheath material 11. In the central portion bounded by the edges 11c, the sheath material 11 functions as a separation barrier separating the interior containing the core material 31 from the outside and, due to pressure difference between the interior and the outside, is in close contact with the core material 31.

The material and form of the core material are not particularly limited as long as they are adapted for heat insulation. Examples of the core material include perlite powder, silica powder, precipitated silica powder, diatomite, calcium silicate, glass wool, rock wool, artificial (synthetic) wool, and foamed resins (such as styrene foam and urethane foam). A hollow container or a honeycomb structure formed in a predetermined shape can also be used as the core material.

### [Electronic device]

An exemplary electronic device having the antistatic sheet of the present invention will now be described. A partial cross-sectional view of the electronic device is shown in FIG. 4. An electronic device 40 of FIG. 4 includes an electronic device body 41, a sealing material 42 for sealing the electronic device body 41, and a protective sheet (antistatic sheet) 43 for protecting the surface of the electronic device body 41. The sealing material 42 covers the entire surface of the electronic device body 41. The protective sheet 43 is disposed over one side of the electronic device body 41, with the sealing material 42 interposed therebetween. On the side opposite to that on which the protective sheet 43 is disposed there may be disposed another protective sheet. In this case, the protective sheet disposed on the opposite side may be the same as or different from the protective sheet 43.

The electronic device body 41 is not particularly limited and is, for example, a photoelectric conversion device such as a solar cell, an information display device such as an organic EL display, liquid crystal display, or electronic paper, or a lighting device such as an organic EL light-emitting element. The sealing material 42 is an optional member that can be added as appropriate depending on, for example, the type and use of the electronic device body 41. Examples of the sealing material 42 include ethylene-vinyl acetate copolymer and polyvinyl butyral. It suffices for the protective sheet 43 to be disposed in such a manner as to protect the surface of the electronic device body 41. The protective sheet 43 may be disposed directly on the surface of the electronic device body 41 or may be disposed over the surface of the electronic device body 41, with another member such as the sealing material 42 being interposed therebetween.

A preferred example of the electronic device body 41 is a solar cell. Examples of the solar cell include a silicon solar cell, a compound semiconductor solar cell, and an organic thin-film solar cell. Examples of the silicon solar cell include a monocrystalline silicon solar cell, a polycrystalline silicon solar cell, and an amorphous silicon solar cell. Examples of the compound semiconductor solar cell include a III-V compound semiconductor solar cell, a II-VI compound semiconductor solar cell, and a I-III-VI compound semiconductor solar cell. Examples of the organic thin-film solar cell include a p-n heterojunction organic thin-film solar cell and a bulk heterojunction organic thin-film solar cell. The solar cell may or may not be an integrated solar cell including a plurality of unit cells connected in series.

Depending on the type of the electronic device body 41, it can be fabricated by a so-called roll-to-roll process. In the roll-to-roll process, a flexible substrate (e.g., a stainless steel substrate or a resin substrate) wound around a feed roll is delivered from the feed roll, an element is formed on this substrate to produce the electronic device body 41, and the electronic device body 41 is wound on a take-up roll. In this case, it is advantageous that the protective sheet 43 be prepared beforehand in the form of a flexible long sheet, more particularly in the form of a wound roll of the long sheet. In an example, the protective sheet 43 delivered from a feed roll is stacked onto the electronic device body 41 that has yet to be wound on the take-up roll and is wound up together with the electronic device body 41. In another example, the electronic device body 41 that has been wound on the take-up roll once may be fed from the roll again and stacked onto the protective sheet 43. In a preferred example of the present invention, the electronic device per se has flexibility.

The protective sheet 43 includes the antistatic sheet of the present invention. The antistatic sheet may consist of a multilayer structure. Alternatively, the antistatic sheet may include a multilayer structure and another member (e.g., the additional layer (J)) stacked on the multilayer structure. The thickness and material of the protective sheet 43 are not particularly limited, as long as the protective sheet 43 is a sheet of layered product suitable for protection of a surface of an electronic device and includes the antistatic sheet described above.

The antistatic sheet of the present invention can be produced as a transparent sheet by forming the antistatic sheet using a transparent base and a transparent layer. The antistatic sheet of the present invention has high barrier performance against oxygen and water vapor and further has antistatic performance. These properties can make a great contribution to the durability of a product fabricated using the antistatic sheet of the present invention, particularly when the product is a solar cell member or display member.

The protective sheet 43 may include, for example, a surface protection layer disposed on one or both of the surfaces of the antistatic sheet. It is preferable for the surface protection layer to be a layer made of a scratch-resistant resin. A surface protection layer for a device such as a solar cell which may be used outdoors is preferably made of a resin having high weather resistance (e.g., light resistance). For protecting a surface required to permit transmission of light, a surface protection layer having high light transmittance is preferred. Examples of the material of the surface protection layer (surface protection film) include poly(meth)acrylic acid ester, polycarbonate, polyethylene terephthalate, polyethylene-2,6-naphthalate, polyvinyl fluoride (PVF), polyvinylidene fluoride (PVDF), polytetrafluoroethylene (PTFE), polychlorotrifluoroethylene (PCTFE), ethylene-tetrafluoroethylene copolymer (ETFE), ethylene-chlorotrifluoroethylene copolymer (ECTFE), tetrafluoroethylene-perfluoroalkyl vinyl ether copolymer (PFA), and tetrafluoroethylene-hexafluoropropylene copolymer (FEP). In an example, the protective sheet includes a poly(meth)acrylic acid ester layer disposed on one of its surfaces.

An additive (e.g., an ultraviolet absorber) may be added to the surface protection layer to increase the durability of the surface protection layer. A preferred example of the surface protection layer having high weather resistance is an acrylic resin layer to which an ultraviolet absorber has been added. Examples of the ultraviolet absorber include, but are not limited to, ultraviolet absorbers based on benzotriazole, benzophenone, salicylate, cyanoacrylate, nickel, or triazine. In addition, another additive such as a stabilizer, light stabilizer, or antioxidant may be used in combination.

The present invention encompasses embodiments obtainable by combining the above features in various manners within the technical scope of the present invention as long as such embodiments exert the effect of the present invention.

### EXAMPLES

Hereinafter, the present invention will be described in more detail by way of examples. The present invention is not limited by these examples in any respect, and it should be understood that many modifications can be made by any ordinarily skilled person in the art within the technical concept of the present invention. Analysis and evaluation in Examples and Comparative Examples given below were performed as will now be described.

### (1) Measurement of infrared absorption spectrum

The measurement was performed by attenuated total reflection spectroscopy using a Fourier transform infrared spectrophotometer. The measurement conditions were as follows.
Apparatus: Spectrum One, manufactured by PerkinElmer, Inc.
Measurement mode: Attenuated total reflection spectroscopy
Measurement range: 800 to 1,400 cm⁻¹

### (2) Cross-sectional observation of multilayer structure

The multilayer structure was machined using a small-size rotary microtome to prepare a section for cross-sectional observation. The prepared section was secured to a sample stage with a carbon tape and sputtered with platinum ions under a vacuum of 7 Pa at a discharge current of 15 mA for 20 seconds, after which the morphology of the multilayer structure was observed in the cross-sectional direction using an ultra-high-resolution field-emission scanning electron microscope. The measurement conditions were as follows.
Apparatus: SU 8010, manufactured by Hitachi High-Technologies Corporation
Accelerating voltage: 1.0 kV
Magnification: × 100,000

### (3) Measurement of oxygen transmission rate

The multilayer structure was attached to an oxygen transmission rate measurement apparatus in such a manner that the layer as the base faced the carrier gas side, and in this state the oxygen transmission rate was measured. The measurement conditions were as follows.
Apparatus: MOCON OX-TRAN 2/20, manufactured by ModernControls, Inc.
Temperature: 20°C
Humidity on oxygen feed side: 85% RH
Humidity on carrier gas side: 85% RH
Oxygen pressure: 1 atm
Carrier gas pressure: 1 atm

### (4) Measurement of moisture permeability

The multilayer structure was attached to a water vapor transmission rate measurement apparatus in such a manner that the layer as the base faced the carrier gas side, and in this state the moisture permeability (water vapor transmission rate) was measured. The measurement conditions were as follows.

Apparatus: MOCON PERMATRAN 3/33, manufactured by ModernControls, Inc.
Temperature: 40°C
Humidity on water vapor feed side: 90% RH
Humidity on carrier gas side: 0% RH

### (5) Measurement of surface electrical resistivity

Electrodes were placed in contact with the outer surface of the multilayer structure remote from the base (X), and the electrodes were connected to a digital ultrahigh-resistance/minute-current ammeter. A voltage was applied between the main electrode and guard electrode according to JIS K 6911 (2006) and JIS C 2139

(2008). In this manner, the surface electrical resistance was measured for the layers (Y) and the surface layers of Comparative Examples. The measurement conditions were as shown below. The surface electrical resistivity was calculated by multiplying the measured value of the surface electrical resistance by 18.84 which is an electrode factor.
Apparatus: R8340A, manufactured by Advantest Corporation
Temperature: 20°C
Voltage: 500 V
Diameter of main electrode: 50 mm
Inner diameter of guard electrode: 70 mm

### (6) Evaluation of adhesion of dust

Flour was placed on the surface of the multilayer structure, and then a blast of air was blown to the surface to remove the flour from the surface. After that, evaluation was made as follows: The multilayer structure was rated as "A" when no flour remained adhering to the surface, as "B" when a slight amount of flour remained adhering to the surface, or as "C" when a large amount of flour remained adhering to the surface.

### <Production example of coating liquid (S-1)>

Distilled water in an amount of 230 parts by weight was heated to 70°C under stirring. Triisopropoxyaluminum in an amount of 88 parts by weight was added dropwise to the distilled water over 1 hour, the liquid temperature was gradually increased to 95°C, and isopropanol generated was distilled off. In this manner, hydrolytic condensation was performed. To the resulting liquid was added 4.0 parts by weight of a 60 wt% aqueous nitric acid solution, and this was followed by stirring at 95°C for 3 hours to deflocculate agglomerates of particles of the hydrolytic condensate. After that, the liquid was concentrated so that the concentration of solids calculated as aluminum oxide was adjusted to 10 wt%. To 22.50 parts by weight of the solution thus obtained were added 54.29 parts by weight of distilled water and 18.80 parts by weight of methanol. This was followed by stirring to obtain a homogeneous dispersion. Subsequently, 4.41 parts by weight of an 85 wt% aqueous phosphoric acid solution was added dropwise to the dispersion under stirring, with the liquid temperature held at 15°C. The stirring was continued at 15°C until a viscosity of 1,500 mPa•s was reached. The intended coating liquid (S-1) was thus obtained. In the coating liquid (S-1), the molar ratio between aluminum atoms and phosphorus atoms, as expressed by aluminum atoms : phosphorus atoms, was 1.15 : 1.00.

### <Synthesis example of polymer (BO-1)>

Under a nitrogen atmosphere, 10 g of vinylphosphonic acid and 0.025 g of 2,2'-azobis(2-amidinopropane) dihydrochloride were dissolved in 5 g of water, and the resulting solution was stirred at 80°C for 3 hours. After being cooled, the polymer solution was diluted by addition of 15 g of water and then filtered using "Spectra/Por" (registered trademark), a cellulose membrane manufactured by Spectrum Laboratories, Inc. Water was removed from the filtrate by distillation, followed by vacuum drying at 50°C for 24 hours, thus giving a polymer (BO-1). The polymer (BO-1) was poly(vinylphosphonic acid). As a result of GPC analysis, the number-average molecular weight of the polymer was determined to be 10,000 on a polyethylene glycol-equivalent basis.

### <Synthesis example of polymer (CBO)>

Under a nitrogen atmosphere, 8.5 g of 2-phosphonooxyethyl methacrylate and 0.1 g of azobisisobutyronitrile were dissolved in 17 g of methyl ethyl ketone, and the resulting solution was stirred at 80°C for 12 hours. The polymer solution obtained was cooled and then added to 170 g of 1,2-dichloroethane. This was followed by decantation to collect the polymer formed as a precipitate. Subsequently, the polymer was dissolved in tetrahydrofuran, and the solution was subjected to purification by reprecipitation using 1,2-dichloroethane as a poor solvent. The purification by reprecipitation was repeated three times, followed by vacuum drying at 50°C for 24 hours to obtain a polymer (CBO). The polymer (CBO) was a polymer of 2-phosphonooxyethyl methacrylate (phosphoric acid group-containing polymer). The polymer (CBO), which has no phosphonic acid group, is not classified as the polymer (BO). As a result of GPC analysis, the number-average molecular weight of the polymer was determined to be 10,000 on a polystyrene-equivalent basis.

### <Production example of coating liquid (T-1)>

The polymer (BO) as obtained in the above synthesis example was dissolved in a mixed solvent of water and methanol (at a weight ratio, water : methanol, of 7 : 3) to obtain a coating liquid (T-1) having a solids concentration of 1 wt%.

### <Production example of coating liquid (T-2)>

The polymer (CBO) as obtained in the above synthesis example was dissolved in a mixed solvent of water and methanol (at a weight ratio, water : methanol, of 7 : 3) to obtain a coating liquid (T-2) having a solids concentration of 1 wt%.

### <Example 1>

First, "Lumirror (registered trademark) P60" (thickness: 12 µm) manufactured by TORAY INDUSTRIES, INC., which is an oriented polyethylene terephthalate film, was prepared as the base (X) (this film may be simply referred to as "X-1" hereinafter). The coating liquid (S-1) was applied onto the base using a bar coater. The film of the applied liquid was dried at 110°C for 5 minutes and then heat-treated at 160°C for 1 minute to form a precursor layer of a layer (Y1-1) on the base. Subsequently, the coating liquid (T-1) was applied using a bar coater in such a manner that the ratio W_{BO}/W_{BI} between the weight W_{BI} of the inorganic phosphorus compound (BI) and the weight W_{BO} of the organic phosphorus compound (BO) would be 5.2/94.8, and the applied liquid was dried at 110°C for 3 minutes. This was followed by heat treatment at 220°C for 1 minute to form the layer (Y1-1). In this way, a multilayer structure (1-1) having a configuration of "base (X-1)/layer (Y1-1)" was obtained.

As a result of measurement of the infrared absorption spectrum of the multilayer structure (1-1), the maximum absorption wavenumber in the region from 800 to 1,400 cm⁻¹ was determined to be 1,108 cm⁻¹, and the width at half maximum of the maximum absorption band in this region was determined to be 37 cm⁻¹.

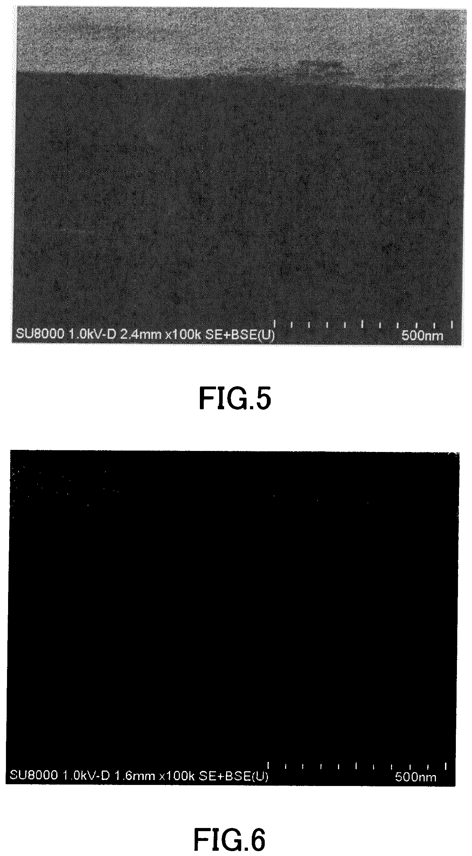

The multilayer structure (1-1) obtained was subjected to cross-sectional observation by the method described above. The result is shown in FIG. 5. The thickness of the layer (Y1-1) was 0.40 µm.

The oxygen transmission rate and moisture permeability of the multilayer structure (1-1) obtained were measured by the methods described above. The multilayer structure (1-1) obtained was subjected to the measurement of the surface electrical resistivity of the layer (Y) and the evaluation of adhesion of dust by the methods described above. The results are shown in Table 1.

### <Example 2>

A multilayer structure (2-1) was fabricated and evaluated in the same manner as the multilayer structure (1-1) of Example 1, except for changing the weight ratio W_{BO}/W_{BI} between the polymer (BO) and the inorganic phosphorus compound (BI) as shown in Table 1. The result of cross-sectional observation is shown in FIG. 6, and the evaluation results are shown in Table 1. The thickness of the layer (Y2-1) was 0.39 µm.

### <Comparative Example 1>

A multilayer structure (C1-1) was fabricated and evaluated in the same manner as the multilayer structure (1-1) of Example 1, except for using the coating liquid (T-2) instead of the coating liquid (T-1). The evaluation results are shown in Table 1.

### <Comparative Example 2>

A multilayer structure (C2-1) was fabricated and evaluated in the same manner as the multilayer structure (1-1) of Example 1, except for omitting the application of the coating liquid (T-1). The evaluation results are shown in Table 1.

Table 1 shows the production conditions and evaluation results for the multilayer structures of Examples and Comparative Examples.

**[Table 1]**

| | Base (X) | Layer (Y) | | | | IR | | Oxygen transmission rate | Moisture permeability | Surface electrical resistivity | Adhesion of dust |
|---|---|---|---|---|---|---|---|---|---|---|---|
| | | Coating liquid (T) | Thickness | Polymer (BO) | Weight ratio | Maximum absorption wavenumber | Width at half maximum | | | | |
| | | No. | µm | | W_{BO}/W_{BI} | cm⁻¹ | cm⁻¹ | mL/(m²•day•atm) | g/(m²• day) | Ω/sq | |
| Example 1 | X-1 | T-1 | 0.40 | PVPA | 0.05 (5.2/94.8) | 1,108 | 37 | 0.20 | 0.20 | 1.74 × 10¹¹ | A |
| Example 2 | X-1 | T-1 | 0.39 | PVPA | 0.16 (14.1/85.9) | 1,108 | 37 | 0.20 | 0.30 | 1.68 × 10¹⁰ | A |
| Comparative Example 1 | X-1 | T-2 | 0.40 | PPEM | 0.05 (5.2/94.8) | 1,108 | 37 | 0.21 | 0.20 | 1.23 × 10¹⁶ | C |
| Comparative Example 2 | X-1 | - | 0.30 | - | - | 1,108 | 37 | 0.19 | 0.20 | 1.59 × 10¹⁵ | C |

| | | | | | | | | | | | |
|---|---|---|---|---|---|---|---|---|---|---|---|
| [Abbreviations in table] PVPA: Poly(vinylphosphonic acid) PPEM: Poly(2-phosphonooxyethyl methacrylate) | | | | | | | | | | | |

Table 1 demonstrates that the antistatic sheet of the present invention has superior gas barrier performance and water vapor barrier performance and further has superior antistatic performance and that the antistatic sheet of the present invention suffers from neither adhesion of fine powder to its surface nor appearance defect.

### INDUSTRIAL APPLICABILITY

The present invention is applicable to an antistatic sheet and to a packaging material and an electronic device that include the antistatic sheet. According to the present invention, it is possible to obtain an antistatic sheet having superior gas barrier performance and water vapor barrier performance and further having superior antistatic performance. The antistatic sheet of the present invention is therefore preferred for use as or in packaging materials for foods, chemicals, medical instruments, industrial materials, electronic equipment, etc. The antistatic sheet of the present invention is preferred also for use as or in: display members such as a substrate film for liquid crystal displays, a substrate film for organic EL devices, a substrate film for electronic paper, a sealing film for electronic devices, and a film for plasma display panels; electronic device-related members such as a film for LEDs, a film for IC tags, a solar cell module, and a solar cell member such as a back sheet or protective film for solar cells; and other electronic device members such as a member for optical communication devices, a flexible film for electronic equipment, a barrier membrane for fuel cells, a sealing film for fuel cells, and a substrate film for various functional films.

## Claims

1. An antistatic sheet comprising a multilayer structure comprising a base (X) and a layer (Y) stacked on the base (X), wherein
the layer (Y) contains an aluminum-containing compound (A), a polymer (BO) having a phosphonic acid unit and an inorganic phosphorus compound (BI),
the layer (Y) has a surface electrical resistivity of 1.0 × 10⁶ Ω/sq or more and 4.0 × 10¹³ Ω/sq or less, and
a ratio W_{BO}/W_{BI} between a weight W_{BI} of the inorganic phosphorus compound (BI) and a weight W_{BO} of the polymer (BO) having the phosphonic acid unit is less than 0.32.

2. The antistatic sheet according to claim 1, wherein the aluminum-containing compound (A) is a compound (Ab) comprising a reaction product (D) of an aluminum-containing metal oxide (Aa) and the inorganic phosphorus compound (BI).

3. The antistatic sheet according to claim 1 or 2, wherein the polymer (BO) having the phosphonic acid unit is a homopolymer or a copolymer of an alkenylphosphonic acid represented by the following general formula [III]:
R⁵⁻P(=O)(OH)₂ [III],
wherein R⁵ is an optionally substituted alkenyl group having 2 to 30 carbon atoms.

4. The antistatic sheet according to claim 1 or 2, wherein the polymer (BO) having the phosphonic acid unit is poly(vinylphosphonic acid).

5. The antistatic sheet according to any one of claims 1 to 4, wherein the base (X) comprises at least one layer selected from the group consisting of a thermoplastic resin film layer, a paper layer, and an inorganic deposited layer.

6. The antistatic sheet according to any one of claims 1 to 5, wherein a moisture permeability as measured at 40°C and 90% RH is 2.0 g/(m²•day) or less.

7. A packaging material comprising the antistatic sheet according to any one of claims 1 to 6.

8. An electronic device comprising the antistatic sheet according to any one of claims 1 to 6.

## Patentansprüche

1. Antistatikfolie, umfassend eine mehrschichtige Struktur, umfassend eine Basis (X) und eine Schicht (Y), gestapelt auf der Basis (X), wobei
die Schicht (Y) eine aluminiumhaltige Verbindung (A), ein Polymer (BO) mit einer Phosphonsäureeinheit und eine anorganische Phosphorverbindung (BI) enthält,
die Schicht (Y) einen elektrischen Oberflächenwiderstand von 1,0 × 10⁶ Ω/sq oder mehr und 4.0 × 10¹³ Ω/sq oder weniger aufweist und
ein Verhältnis W_{BO}/W_{BI} zwischen einem Gewicht W_{BI} der anorganischen Phosphorverbindung (BI) und einem Gewicht W_{BO} des Polymers (BO) mit der Phosphonsäureeinheit weniger als 0,32 beträgt.

2. Antistatikfolie nach Anspruch 1, wobei die aluminiumhaltige Verbindung (A) eine Verbindung (Ab), umfassend ein Reaktionsprodukt (D) eines aluminiumhaltigen Metalloxids (Aa) und der anorganischen Phosphorverbindung (BI), ist.

3. Antistatikfolie nach Anspruch 1 oder 2, wobei das Polymer (BO) mit der Phosphonsäureeinheit ein Homopolymer oder ein Copolymer einer Alkenylphosphonsäure, dargestellt durch die folgende allgemeine Formel [III], ist:
R⁵-P(=O)(OH)₂ [III],
wobei R⁵ eine gegebenenfalls substituierte Alkenylgruppe mit 2 bis 30 Kohlenstoffatomen ist.

4. Antistatikfolie nach Anspruch 1 oder 2, wobei das Polymer (BO) mit der Phosphonsäureeinheit Poly(vinylphosphonsäure) ist.

5. Antistatikfolie nach einem der Ansprüche 1 bis 4, wobei die Basis (X) mindestens eine Schicht, ausgewählt aus der Gruppe, bestehend aus einer thermoplastischen Harzfilmschicht, einer Papierschicht und einer anorganischen abgeschiedenen Schicht, umfasst.

6. Antistatikfolie nach einem der Ansprüche 1 bis 5, wobei eine Feuchtigkeitsdurchlässigkeit, gemessen bei 40°C und 90% relativer Luftfeuchte, 2,0 g/(m²·Tag) oder weniger beträgt.

7. Verpackungsmaterial, umfassend die Antistatikfolie nach einem der Ansprüche 1 bis 6.

8. Elektronische Vorrichtung, umfassend die Antistatikfolie nach einem der Ansprüche 1 bis 6.

## Revendications

1. Feuille antistatique comprenant une structure multicouche comprenant une base (X) et une couche (Y) empilée sur la base (X), où
la couche (Y) contient un composé contenant de l'aluminium (A), un polymère (BO) ayant une unité acide phosphorique et un composé inorganique du phosphore (BI), la couche (Y) a une résistivité électrique surfacique de 1,0 x 10⁶ Ω/sq ou plus et de 4,0 x 10¹³ Ω/sq ou moins, et
le rapport W_{BO}/W_{BI} entre le poids W_{BI} du composé inorganique du phosphore (BI) et le poids W_{BO} du polymère (BO) ayant l'unité acide phosphorique est inférieur à 0,32.

2. Feuille antistatique selon la revendication 1, où le composé contenant de l'aluminium (A) est un composé (Ab) comprenant un produit de réaction (D) d'un oxyde métallique contenant de l'aluminium (Aa) et du composé inorganique du phosphore (BI).

3. Feuille antistatique selon la revendication 1 ou 2, où le polymère (BO) ayant l'unité acide phosphorique est un homopolymère ou un copolymère d'un acide alcénylphosphonique représenté par la formule générale [III] suivante :
R⁵⁻P(=O)(OH)₂ [III]
où R⁵ est un groupe alcényle optionnellement substitué, ayant 2 à 30 atomes de carbone.

4. Feuille antistatique selon la revendication 1 ou 2, où le polymère (BO) ayant l'unité acide phosphorique est le poly(acide vinylphosphonique).

5. Feuille antistatique selon l'une quelconque des revendications 1 à 4, où la base (X) comprend au moins une couche choisie parmi le groupe consistant en une couche en film de résine thermoplastique, une couche de papier et une couche inorganique déposée.

6. Feuille antistatique selon l'une quelconque des revendications 1 à 5, où la perméabilité à l'humidité, mesurée à 40°C et 90% d'HR, se situe à 2,0 g/(m².jour) ou moins.

7. Matériau d'emballage comprenant la feuille antistatique selon l'une quelconque des revendications 1 à 6.

8. Dispositif électronique comprenant la feuille antistatique selon l'une quelconque des revendications 1 à 6.
